Europäisches Patentamt

European Patent Office

Office européen des brevets

(11) Publication number: **0 262 794 B1**

# EUROPEAN PATENT SPECIFICATION

(45) Date of publication of patent specification: 02.05.91  (51) Int. Cl.⁵: **H05K 9/00**

(21) Application number: 87307629.3

(22) Date of filing: 28.08.87

(54) Securing objects.

(30) Priority: 30.08.86 GB 8621035

(43) Date of publication of application:
06.04.88 Bulletin 88/14

(45) Publication of the grant of the patent:
02.05.91 Bulletin 91/18

(84) Designated Contracting States:
BE DE FR NL

(56) References cited:
DE-A- 2 904 937
DE-C- 866 358
DE-U- 1 615 700
DE-U- 7 025 106
US-A- 3 147 336

(73) Proprietor: THE MARCONI COMPANY LIMITED
The Grove Warren Lane
Stanmore Middlesex HA7 4LY(GB)

(72) Inventor: Henderson, William Iain Mackie
91 Edge Hill Darras Hall
Ponteland Northumberland NE20 9JQ(GB)
Inventor: Morrison, David John
5 Hobart Whitley Bay
Tyne & Wear NE26 3TA(GB)
Inventor: Smith, Moira

19 Foxhills Covert
Wickam Newcastle NE16 5TN(GB)
Inventor: Thornley, David John
4 Sunny Brae Ryton
Tyne & Wear NE40 4JB(GB)
Inventor: Leask, Samuel Hall
27 Walworth Avenue
Narsden Estate South Shields NE34 7EP(GB)
Inventor: Matthews, Christopher F.
Dere Hollow
Riding Hill Northumberland NE44 5DQ(GB)

(74) Representative: Waters, Jeffrey
The General Electric Company plc Central
Patent Department Marconi Research Centre
West Hanningfield Road
Great Baddow Chelmsford Essex CM2
8HN(GB)

## Description

This invention relates to an arrangement for securing objects to a panel designed to provide shielding against electromagnetic interference.

This invention arose in the design of a transportable electrical equipment container made from a frame carrying panels forming the walls, floor and roof. The panels were formed from a central layer of an electrically insulating foam and outer layers of aluminium, which is conductive and provides the required shielding.

A problem was encountered in securing equipment to the panels on the inside of the container since any holes drilled through the inner aluminium layer allowed leakage into the container of any electromagnetic interference which might have penetrated through the outer layer of aluminium.

This invention provides an arrangement for securing objects to a panel designed to provide shielding against electromagnetic interference, the arrangement comprising: a cavity in the panel opening into an electrically conductive surface thereof, a receptacle which fits into the cavity and has a flange which rests against and makes electrical contact with a part of the electrically conductive surface surrounding the cavity; and a body of material which is secured in the receptacle and which receives or is about to receive a fastening device.

By employing the invention the receptacle provides a continuous conductive inner surface to the panel and so avoids the problem of the leakage of the electromagnetic interference.

To ensure good electrical contact between the receptacle and the conductive layer a lip is preferably formed by swaging or otherwise deforming the material of the receptacle after it has been inserted into the cavity thereby nipping the conductive surface of the panel between the flange and the lip. The layer of electrically insulating material will normally be foam plastics or some other material which is relatively compressible compared to the material forming the conductive surface of the panel. This enables it to be compressed during the swaging process.

To give improved shielding against electromagnetic interference there is preferably a second electrically conductive layer on a side of the layer of insulating material opposite to the first electrically conductive layer. The base of the receptacle, which is preferably flat, may rest against this second conductive layer to give extra support.

The body of material inside the receptacle can take any form which serves its purpose i.e. of providing a mechanical connection between the fastening device and the inside surface of the receptacle. In one embodiment it takes the form of a plastic insert secured inside the receptacle with adhesive, this plastic insert having a hole in it to take a fastening device in the form of a self-tapping screw. Alternatively the inside of this plastic insert could be threaded to accept a bolt.

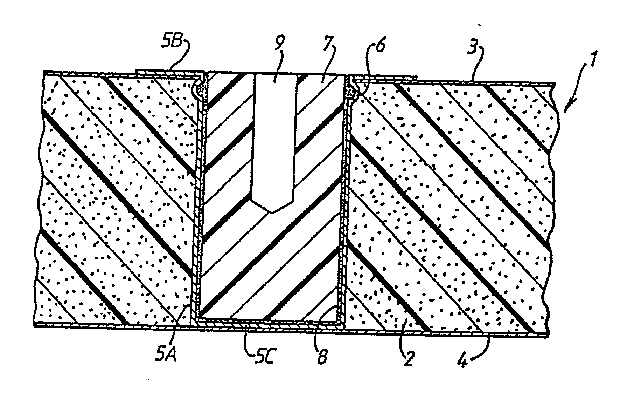

A preferred embodiment of the invention will now be described with reference to the accompanying drawing which shows a horizontal cross-section through an arrangement for securing objects to a panel.

A container designed to exclude electromagnetic radiation at radio frequency is formed from panels, one of which is shown at 1 and comprises an inner layer 2 of rigid foam plastics, which is electrically and thermally insulating, and outer layers 3 and 4 of aluminium, which provide shielding against electromagnetic interference. The layer 3 is on the inside of the container.

A cylindrical cavity is formed by drilling through layers 2 and 3. A receptacle 5, made from aluminium, has a body 5A, flange 5B and end face 5C. The body 5A of the receptacle is inserted into the cavity so that its end face 5C rests against layer 4 and the flange 5B rests against a region of layer 3 bordering the cavity.

After insertion a swaging operation is performed to form a lip 6. During this process the aforementioned region of the layer 3 bordering the cavity is nipped between the lip 6 and the flange 5B. This gives good mechanical support to the receptacle and ensures that the receptacle and layer 3 are in good electrical contact all around the edge of the cavity.

A nylon insert 7 is then secured in the receptacle by an adhesive layer 8. In the illustrated embodiment the insert 7 has a pre-formed hole 9 to accept a self-tapping screw, though in alternative embodiments the hole could be formed with a thread; or could be replaced by a fastening device embedded in the insert 7.

The electrically insulating properties of the nylon of the insert 7 is of significance since it enables equipment to be fixed to the inside surfaces of the container without making electrical contact therewith.

## Claims

1.  An arrangement for securing objects to a panel (1) designed to provide shielding against electromagnetic interference, characterised by: a cavity in the panel (1) opening into an electrically conductive surface (3) thereof, a receptacle (5) which fits into the cavity and provides a continuous conductive inner surface to the panel and has a flange (5B) which rests against and makes electrical contact with a part of the electrically conductive surface (3) surrounding the cavity; and a body (7) of material which is secured in the receptacle and which receives or is adapted to receive a fastening device.

2. An arrangement according to claim 1 characterised in that the panel (1) comprises a layer (2) of electrically insulating material and a conductive layer (3) bonded to it and forming the electrically conductive surface, and in that the receptacle (5) is deformed outwardly in the vicinity of the flange to form a lip (6) so that a border region of the conductive layer surrounds the cavity and is held between the lip (6) and the flange.

3. An arrangement according to claim 2 characterised in that the lip (6) is formed by a swaging process.

4. An arrangement according to claims 2 or 3 in which the electrically insulating material (2) is relatively compressible compared with the material forming a conductive layer (3).

5. An arrangement according to claim 2, 3 or 4 characterised by a second electrically conductive layer (4) on a side of the layer of insulating material opposite to the first mentioned electrically conductive layer (3) and in that a face (5C) of the receptacle rests against the second layer.

6. An arrangement according to any preceding claim characterised in that the body (2) of material is secured in the cavity by adhesive.

7. An arrangement according to any preceding claim characterised in that the body (2) of material is electrically insulating.

**Revendications**

1. Moyen permettant de fixer des objets à un panneau (1) conçu pour produire un blindage contre des interférences électromagnétiques, caractérisé par : une cavité ménagée dans le panneau (1), ouvrant dans une surface électriquement conductrice (3) de celui-ci ; un réceptacle (5) s'ajustant dans la cavité, offrant une surface interne conductrice continue au panneau et possédant un rebord (5B) qui repose contre une partie de la surface électriquement conductrice (3) entourant la cavité et établit un contact électrique avec cette partie ; et un corps (7) de matériau qui est fixé dans le réceptacle et qui reçoit ou est conçu pour recevoir un dispositif de fixation.

2. Moyen selon la revendication 1, caractérisé en ce que le panneau (1) comprend une couche (2) de matériau électriquement isolant et une couche conductrice (3) liée à celle-ci et formant la surface électriquement conductrice, et en ce que le réceptacle (5) est soumis à une déformation dirigée vers l'extérieur au voisinage du rebord afin de former une gorge (6), de façon qu'une région de bordure de la couche conductrice entoure la cavité et soit maintenue entre la gorge (6) et le rebord.

3. Moyen selon la revendication 2, caractérisé en ce qu'on forme la gorge (6) par une opération de matriçage.

4. Moyen selon la revendication 2 ou 3, où le matériau électriquement isolant (2) est relativement compressible par rapport au matériau formant une couche conductrice (3).

5. Moyen selon la revendication 2, 3 ou 4, caractérisé par une deuxième couche électriquement conductrice (4) se trouvant sur le côté de la couche de matériau isolant qui est opposé à la couche électriquement conductrice (3) mentionnée en premier, et en ce qu'une face (5C) du réceptacle repose contre la deuxième couche.

6. Moyen selon l'une quelconque des revendications précédentes, caractérisé en ce que le corps (2) de matériau est fixé dans la cavité par un adhésif.

7. Moyen selon l'une quelconque des revendications précédentes, caractérisé en ce que le corps (2) de matériau est électriquement isolant.

**Ansprüche**

1. Anordnung zum Befestigen von Gegenständen an einer Tafel (1), die zum Abschirmen gegen Elektromagnetstörungen ausgelegt ist, gekennzeichnet durch: einen Hohlraum in der Tafel (1), der sich in eine elektrisch leitende Oberfläche (3) derselben öffnet; eine Aufnahme (5), die in den Hohlraum paßt und eine kontinuierliche leitende Innenfläche für die Tafel schafft und einen Flansch (5B) besitzt, der gegen einen Teil der den Hohlraum umgebenden elektrisch leitenden Fläche (3) anliegt und mit diesem elektrischen Kontakt herstellt; und einen Materialkörper (7), der in der Aufnahme befestigt ist und ein Befestigungselement aufnimmt oder zur Aufnahme eines solchen ausgelegt ist.

2. Anordnung nach Anspruch 1, dadurch gekennzeichnet, daß die Tafel (1) eine Schicht (2) aus elektrisch isolierendem Material und eine damit verbundene, die elektrisch leitende Oberfläche bildende leitende Schicht (3) umfaßt, und daß die Aufnahme (5) in der Umgebung des Flansches zur Bildung einer Lippe (6) nach außen verformt ist, so daß ein Grenzbereich der Leitschicht den Hohlraum umgibt und zwischen der Lippe (6) und dem Flansch gehalten ist.

3. Anordnung nach Anspruch 2, dadurch gekennzeichnet, daß die Lippe (6) durch einen Drückvorgang gebildet ist.

4. Anordnung nach Anspruch 2 oder 3, bei der das elektrisch isolierende Material (2) im Vergleich zu dem eine Leitschicht (3) bildenden Material relativ kompressibel ist.

5. Anordnung nach Anspruch 2, 3 oder 4, gekennzeichnet durch eine zweite elektrisch leitende Schicht (4) an einer der zuerst erwähnten elektrisch leitenden Schicht (3) gegenüberliegenden Seite der isolierenden Materialschicht und dadurch, daß eine Fläche (5C) der Aufnahme gegen die zweite Schicht anliegt.

6. Anordnung nach einem der vorangehenden Ansprüche, dadurch gekennzeichnet, daß der Materialkörper (7) in dem Hohlraum durch Kleber befestigt ist.

7. Anordnung nach einem der vorangehenden Ansprüche, dadurch gekennzeichnet, daß der Materialkörper (7) elektrisch isolierend ist.